# EUROPEAN PATENT APPLICATION

(11) **EP 4 528 820 A1**
(43) Date of publication of application: **26.03.2025**
(21) Application number: 23198807.2
(22) Date of filing: 21.09.2023
(51) Int. Cl.: H01L 29/423, H01L 29/49, H01L 29/78, H01L 21/336

(54) **SEMICONDUCTOR DEVICE AND METHOD OF MANUFACTURING THE SAME**

(71) Applicant: Infineon Technologies Austria AG, 9500 Villach (AT)
(72) Inventor: FEIL, Thomas, 9523 Villach (AT)
(74) Representative: Szynka Smorodin Patentanwälte Partnerschaft mbB

(57) **Abstract**

The disclosure relates to a semiconductor device (1) having a gate electrode (4) in a vertical gate trench (5); a channel region (6) laterally aside the gate trench (5); wherein the gate electrode (4) comprises an outer gate region (8) made of an outer gate material (80); a metal inlay region (9) made of a metal material (90); a spacer region (10); wherein the outer gate material (80) and the spacer region (10) are each different from the metal material (90), and wherein the spacer region (10), the metal inlay region (9) and the outer gate region (8) are, at least in a vertical section (4.1) of the gate electrode (4), consecutively arranged from a center position (20) within the gate electrode (4) laterally outwardly towards the channel region (6).

## Description

### TECHNICAL FIELD

The present disclosure relates to a semiconductor device and a method of manufacturing the same.

### BACKGROUND

The semiconductor device may have a gate electrode in a vertical gate trench, wherein a channel region is arranged laterally aside the gate trench. By applying a voltage to the gate electrode, a channel formation in the channel region may be triggered. Depending on the particular device, a vertical current flow in the channel region may result, for instance between a source and a drain region.

### SUMMARY

Examples of the present disclosure are directed at an advantageous semiconductor device with a gate electrode in a vertical gate trench.

In an embodiment, the gate electrode comprises an outer gate region, a metal inlay region and a spacer region. From a center position within the gate electrode, the spacer region, the metal inlay region and the outer gate region are consecutively arranged laterally outwardly towards the channel region. In other words, the outer gate region is laterally closer to the channel region than the metal inlay region and the metal inlay region is laterally closer to the channel region than the spacer region, which may apply at least for a vertical section of the gate electrode, not necessarily over its entire vertical height.

The outer gate material, which lies close or adjacent to a gate dielectric, can for example be chosen for a work function optimization. This may for instance enable a small work function difference and low threshold voltage. Vice versa, the metal material of the metal inlay region may for instance reduce the electrical resistance of the gate electrode. However, the metal inlay may not fill an inner portion of the gate electrode completely, instead a spacer region may be provided. In comparison to a full metal inlay, the spacer region can for instance reduce a mechanical stress, for example a compressible stress along the channel region thereby increasing the mobility and decreasing the resistance of the semiconductor device.

Particular embodiments and features are provided throughout this disclosure and in particular in the dependent claims. Thereby, the individual features shall be disclosed independently of a specific claim category, the disclosure relates to apparatus and device aspects, but also to method and use aspects. If for instance a device manufactured or used in a specific way is described, this is also a disclosure of a respective manufacturing process or use, and vice versa. In general words, an approach of this disclosure is to provide a gate electrode with a spacer region, in particular laterally inside a metal inlay region. Depending for instance on the geometry, the spacer region may also simplify the manufacturing (for instance compared to a complete metal inlay).

The "consecutive arrangement" of the spacer region, the metal inlay region and the outer gate region relates to a lateral direction, for instance a first lateral direction. In a second lateral direction lying obliquely or perpendicular to the first lateral direction, the gate electrode and gate trench can have an elongated extension. In other words, the lateral consecutive arrangement may be visible in a vertical cross-section perpendicular to a length extension of the gate electrode. Seen for instance in the cross-section, the outer gate region may lie adjacent to the gate dielectric and/or the metal inlay region may lie adjacent to the outer gate region, for instance apart from a silicide/barrier layer in between, and/or the spacer region may lie adjacent to the metal inlay region.

The "center position", to which the lateral arrangement refers, lies in the gate electrode, for instance centrally when viewed in a vertical cross-section. As detailed below, the gate electrode may in particular have a symmetrical design, the center position being for instance a mirror symmetry axis or lying on a mirror symmetry axis. The lateral arrangement exists at least over a "vertical section" of the gate electrode, e. g. not necessarily over its entire height. The vertical section can for instance have at least a vertical overlap with the channel region, in particular it may vertically extend over the entire vertical height of the channel region. Below or above the vertical section, the gate electrode may have a different setup or geometry, for instance only one or some of the regions may be present there.

"Vertical" or "vertically" refer to the vertical direction which lies for instance perpendicular to a surface of the device, for instance a surface of a substrate or an epitaxial layer formed on the substrate. "Above" means closer to a first side of the semiconductor body (e.g., a side where a source terminal may be connected to) or device and "below" means closer to the vertically opposite second side of the semiconductor body or device (e.g., a side where a drain terminal may be connected to). An upper portion of an element or region is for instance closer to the first side than a lower portion of the same element or region. "Lateral" or "laterally" refer to the lateral directions perpendicular to the vertical direction, in which for instance an area of the device or die is taken. In particular, a first lateral direction can be the cross direction of the gate electrode or gate trench, wherein a second lateral direction is its length direction.

Together with a gate dielectric, the gate electrode may form a gate region of the device. Seen for instance in a vertical top view, the gate trench and gate electrode can have an elongated extension, for instance form a stripe or grid pattern depending on a cell layout. In general, the semiconductor device may be any type of gate-controlled device with a gate electrode in a trench, for instance an IGBT or a lateral device with both load contacts on the same side of the semiconductor body (and a channel aside the gate trench). In particular, the device is a vertical transistor device having its load contacts at opposite sides of a semiconductor body.

At a first side of the semiconductor body, from which the gate trench extends into the semiconductor body, a source region of the vertical transistor device may be arranged, wherein its drain region is arranged at the vertically opposite second side of the semiconductor body. In between, a body region laterally aside the gate trench is disposed, in which the channel region is formed. Additionally, the transistor device may comprise a drift region vertically between the body and the drain region, made of the same doping type like the drain region but with a lower doping concentration. The source region, drain region and drift region may be made of a first doping type and the body region may be made of a second doping type, wherein in the exemplary embodiments the first type is n-type and the second type is p-type. Considering the semiconductor device or die as a whole, decreasing the electrical resistance of the gate electrode with the metal inlay region may for instance reduce the gate contacts or gate contact runners required (per area). This in turn can for example reduce a complexity in testing and wiring or reduce an area consumption. Apart from that, for instance in case of a layout where the gate resistance is coupled to an output resistance, the latter becoming small (e.g., smaller than the gate resistance) might also cause problems in damping overshoots. Still further, a low gate resistance may for instance support fast switching.

Vice versa, apart from a different work function, a full metal gate or even full metal inlay may in some cases cause mechanical stress. The spacer region having different mechanical properties than the metal material can for instance introduce less mechanical stress into the gate electrode or even serve as kind of a buffer zone. In general, the spacer region may even be a cavity or void, e. g. not be filled with a solid-state material. Independently of whether a quasi-vacuum or gas is present in this cavity, it has different mechanical properties than the metal inlay region. As such, a gate electrode that comprises a metal inlay and a spacer region adjacent to the metal inlay may allow a reduced resistance of the gate electrode whilst reducing mechanical stress within the gate electrode.

In an embodiment, the spacer region is made of a spacer material which is different from the metal material of the metal inlay region. In particular, the spacer material can be a non-metallic material. Compared to a metal, a non-metallic material can, for example, have a lower coefficient of thermal expansion, which may reduce a mechanical stress in manufacturing or use.

In an embodiment, the spacer material is a silicon material. The silicon material comprises silicon, for instance as a component of a compound or exclusively, for example amorphous silicon or polysilicon. In particular, the silicon material may be an electrically insulating material, for instance silicon nitride or in particular silicon oxide. In general, the gate electrode may comprise another region or regions in addition to the spacer region, for instance a central void region or another layer or layers (e. g. silicon and/or silicon oxide). In particular, however, a central portion of the gate electrode is completely filled by the spacer region which may in particular be made of silicon oxide.

In an embodiment, the outer gate material is an electrically conductive silicon material. This can for instance allow for a small work function difference, e. g. compared to a full metal gate. The latter might require a strongly reduced body doping to achieve a comparable threshold voltage, which might for instance result in a very low channel doping with increased leakage. In particular for a decreasing gate dielectric thickness, a full or direct metal gate might also be expected to create reliability issues. Independently of these details, the electrically conductive silicon material can for instance be amorphous silicon or in particular polysilicon, for instance n-doped or p-doped polysilicon.

In an embodiment, the metal inlay region has a lateral thickness of 200 nm at maximum. Even a comparably thin metal liner may still be sufficient to reduce the electrical resistance, whereas the thickness limitation may for instance reduce the mechanical stress. Further upper limits of the lateral thickness of the metal inlay region may be 150 nm, 100 nm, 80 nm or 60 nm, lower limits being for instance 20 nm, 30 nm or 40 nm. In the exemplary embodiments, it has a lateral thickness of around 50 nm.

As discussed above, the lateral stack with the spacer region, the metal inlay region and the outer gate region does not necessarily exist over the whole vertical height of the gate electrode. In an embodiment, the metal inlay region extends further upwards than the outer gate region. In other words, an upper end of the metal inlay region can lie on a larger vertical height than an upper end of the outer gate region. The metal inlay region protruding upwards from the outer gate region may be used for increasing or adapting the electrical resistance of the gate electrode. A larger vertical protrusion of the metal inlay region can reduce the electrical resistance, whereas for instance a smaller vertical protrusion of the metal inlay region may reduce a gate-source-capacitance. As to the lower ends of the outer gate region and the metal inlay region, they can lie on a different or on the same vertical height.

In an embodiment, an insulating layer arranged on the first side of the semiconductor body is made of the same continuous spacer material like the spacer region. In other words, the spacer region and the insulating layer may be formed in the same process step, the deposited spacer material filling a central portion of the gate electrode and forming the insulating layer on the first side of the semiconductor body. The spacer material can for instance be borophosphosilicate glass (BPSG) or an oxide, for instance silicon oxide, in particular a doped oxide.

In an embodiment an additional insulating layer is arranged on the first side of the semiconductor body, namely below the insulating layer made of the spacer material. The additional insulating layer can for instance be undoped oxide, e. g. silicon oxide, for instance plasma oxide. To summarize, the insulating layer stack may for instance comprise an HDPE oxide layer with a doped oxide layer above, the latter forming the spacer material. It can consist of two layers, e. g. the insulating layer and the additional insulating layer, or comprise another insulating layer in between, for instance a further undoped oxide layer that may be followed by a reflown doped oxide. Independently of these details, the additional insulating layer may for instance be used as a hard mask in an etch step, see in detail below. As to the device, the additional insulating layer may for example cover the outer gate region vertically upwards and be interrupted above the spacer region.

In an embodiment, at least one of a barrier layer and a silicide layer is arranged laterally between the outer gate region and the metal inlay region. The barrier layer can for instance comprise titanium (Ti) and/or tungsten (W) and/or tantalum (Ta), for example in combination with nitrogen (N) and/or carbon (C). Examples include, but are not limited to, TiN, TiW, tungsten nitride (W₂N, WN, WN₂), TaN and so on. The silicide layer may in particular be arranged laterally between the outer gate region and the barrier layer. It can for instance be formed by thermally treating a thin layer deposited for that purpose, namely a silicide formation layer, to let metal atoms diffuse out of the thin layer, for instance Ti-layer.

In an embodiment, in a lateral portion of the gate electrode, where a vertical gate contact contacts the gate electrode, the gate electrode is provided without the spacer region. In particular, it can also be provided without the metal inlay region there. In other words, the outer gate material, in particular silicon gate material, can be left in place in this portion, which may for instance simplify a vertical contact formation and/or allow for the same vertical contact as in case of a full silicon gate.

In an embodiment, the gate electrode has a symmetrical design, an additional channel region arranged at the laterally opposite side of the gate trench. Here, "laterally opposite" can refer to the first lateral direction (cross direction). A vertical axis of mirror symmetry can in particular pass through the spacer region centrally, see above. In other words, the gate electrode may comprise an additional (second) outer gate region and an additional (second) metal inlay region, consecutively arranged from the center position within the gate electrode laterally outwardly towards the additional channel region. Viewed in a vertical cross-section, the first and second outer gate region and/or the first and second metal inlay region may respectively be connected to each other, for instance in a lower portion of the gate electrode. In particular, however, the spacer region may vertically intersect the gate electrode completely, when viewed in the vertical cross-section. Manufacturing wise, the trench may initially be filled with a continuous outer gate material which is subsequently shaped into the first and second outer gate region in an etch step.

The disclosure relates also to a method of manufacturing a semiconductor device, in particular a semiconductor device as discussed above. The method may comprise:
i.) etching the vertical gate trench;
ii.) depositing the outer gate material into the vertical gate trench;
iii.) etching into the outer gate material in the vertical gate trench to form the outer gate region;
iv.) depositing the metal material into the vertical gate trench to form the metal inlay region;
v.) forming the spacer region.

In case of a spacer region made of a solid-state spacer material, step v.) can comprise a deposition of the spacer material into the gate trench. Prior to step ii.), a gate dielectric may be formed in the gate trench, for instance be deposited or thermally grown. In step iii.), a hard mask arranged on the first side of the semiconductor body may be used to define an area for the etch step. In particular, the additional insulating layer discussed above may serve as a hard mask, so that the hard mask is not removed subsequent to the etch step.

In an embodiment, an etching step to etch back the metal material is applied between step iv.) and step v.). This can for instance be an anisotropic etching leaving a metal material layer on the inner sidewall of the outer gate region (the side wall facing away from the channel region). In general, however, the metal deposition in step iv.) may also be adapted to leave the spacer region without requiring a subsequent etch back.

In an embodiment, a gate electrode with a silicide layer may be formed by depositing a silicide formation layer and annealing the silicide formation layer to form the silicide. The silicide can in particular be formed prior to step iv.), in particular prior to the deposition of a barrier layer.

A contact plug of the device, in particular source contact plug, may also comprise a silicide layer. The contact plug may in particular be a body/source contact plug, the silicide forming the electrical contact to the body and the source region. The silicide layer of the contact plug may in particular be formed after the silicide layer of the gate electrode so that a thermal budget is not restricted. Otherwise, the silicide of the contact plug might grow, for instance undefined into the body region/towards the channel.

### BRIEF DESCRIPTION OF THE DRAWINGS

Below, the device and its manufacturing are explained in further detail by means of exemplary embodiments. Therein, the individual features can also be relevant in a different combination.
- Figure 1: shows a schematic cross-section through a device with a gate electrode in a gate trench;
- figure 2: shows a detailed view of the gate electrode of figure 1;
- figures 3 a-e: show different steps of manufacturing the gate electrode;
- figure 4: shows a flow diagram summarizing some manufacturing steps.

### PARTICULAR EMBODIMENT

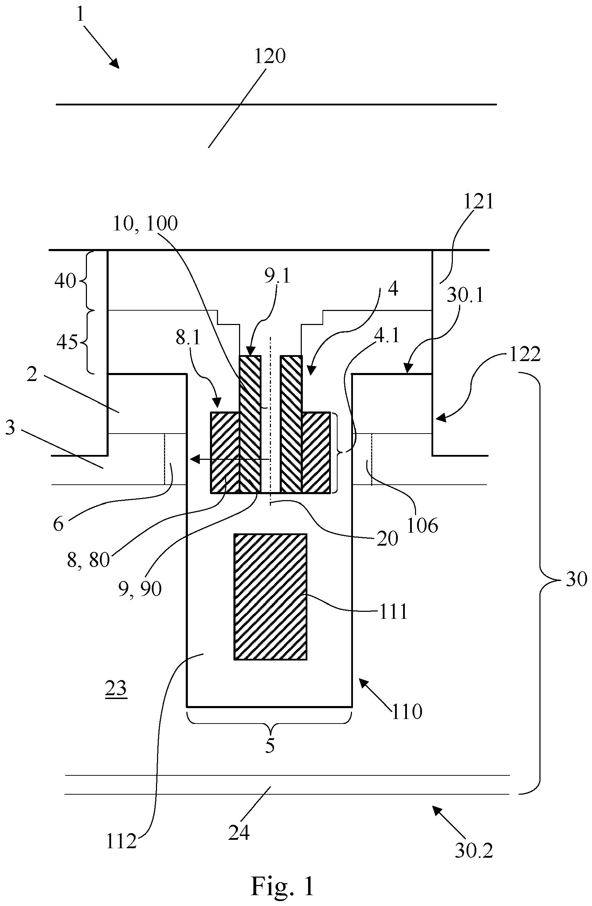

**Figure 1** shows a cross-sectional view through a semiconductor device 1. On a first side 30.1 of a semiconductor body 30, it comprises a source region 2 above a body region 3. Laterally aside the body region 3, a gate electrode 4 is arranged in a vertical gate trench 5. The gate electrode 4 capacitively couples to a channel region 6 which is formed in the body region 3. Below the channel region 6, a drift region 23 is formed. It has the same doping type but a lower doping concentration than a drain region 24 arranged at the second side 30.2 of the semiconductor body 30. In the example shown, the source region 2, the drift region 23 and the drain region 24 are n-doped and that the body region 3 is p-doped.

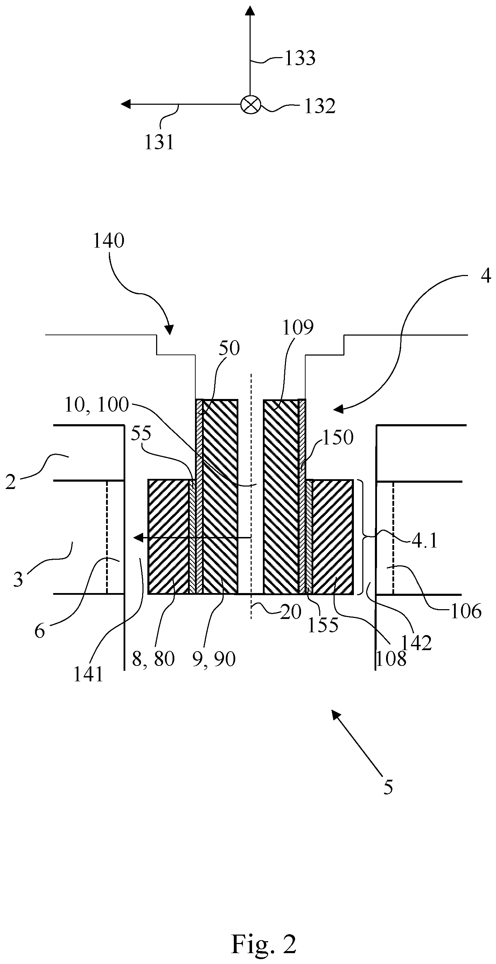

The gate electrode 4 comprises an outer gate region 8 which is made of an outer gate material 80. In addition, it comprises a metal inlay region 9 made of a metal material 90 as well as a spacer region 10. In the example shown, the outer gate material 80 is doped polysilicon and the metal material 90 is tungsten. Regarding further details of the layer stack in between, reference is made to figure 2. The spacer region 10 is made of a spacer material 100 which is BPSG in this example.

Referring to a center position 20 within the gate electrode 4, the spacer region 10, the metal inlay region 9 and the outer gate region 8 are consecutively arranged laterally outwardly towards the channel region 6. This applies in a vertical section 4.1 of the gate electrode 4, namely in a lower portion of it. In an upper portion of the gate electrode 4, the metal inlay region 9 protrudes from the outer gate region 8, an upper end 9.1 of the metal inlay region 9 lying on a larger vertical height than an upper end 8.1 of the outer gate region 8.

On the first side 30.1 of the semiconductor body 30, an insulating layer 40 is arranged, wherein an additional insulating layer 45 is disposed between the insulating layer 40 and the semiconductor body 30. The additional insulating layer 45, which may be used as a hard mask during the fabrication of the gate electrode 4 (see below), may be made of an undoped silicon oxide, for instance plasma oxide. The insulating layer 40 is made of BPSG, namely of the same continuous spacer material 100 like the spacer region 10.

On the insulating layer 40, a metallization 120 is arranged, which may be a metallization stack or one single source metal plate. Via a source contact plug 121 (referenced only on the right, symmetrical design), the metallization 120 is connected to the source region 2 and to the body region 3. The source contact plug 121 connects to the source and body region 2, 3 via a silicide layer 122 which is not shown in further detail here.

In Figure 1, below the gate electrode 4, a field electrode region 110 is arranged in the gate trench 5. The field electrode region 110 comprises a field electrode 111 and a field dielectric 112 which capacitively couples the field electrode 111 to the drift region 23 for a field shaping. However, the field electrode region 110 may also not be present or may be arranged outside of the gate trench 5, such as in an additional elongate trench adjacent to the gate trench 5 or in one or more columnar or needle-shaped trenches adjacent to the gate trench 5. The present disclosure also contemplates such alternative arrangements of the field electrode region 110 and is not limited to the field electrode region 110 being arranged in the gate trench 5.

**Figure 2** shows the gate electrode 4 in a more detailed view. Generally, in this disclosure, the like reference numerals are used for the like elements and reference is respectively made to the description of the other figures as well. The gate electrode 4 belongs to a gate region 140 which additionally comprises a first gate dielectric 141 and a second gate dielectric 142. Via the first gate dielectric 141, the gate electrode 4 couples to the channel region 6 and via the second gate dielectric 142 the gate electrode 4 couples to the additional channel region 106.

In addition to the spacer region 10, the metal inlay region 9 and the outer gate region 8, figure 2 shows a barrier layer 50 and a silicide layer 55. In the vertical section 4.1 of the gate electrode 4, the silicide layer 55 is arranged laterally between the outer gate region 8 and the barrier layer 50 is arranged laterally between the silicide layer 55 and the metal inlay region 9. The barrier layer 50 may for instance be a titanium nitride layer.

The first lateral direction 131 is a cross direction of the gate trench 5, in a second lateral direction 132 it has an elongated extension. Both lateral directions 131, 132 lie perpendicular to a vertical direction 133. Figure 2 also illustrates the symmetrical design of the gate electrode 4. On a laterally opposite side wall of the gate trench 5, an additional channel region 106 is arranged, and the gate electrode 4 comprises an additional outer gate region 108, an additional silicide layer 155, an additional barrier layer 150 and an additional metal inlay region 109. The additional channel region 106 may be connected in parallel to the channel region 6, for instance belong to another device cell assigned to the same drain region 24.

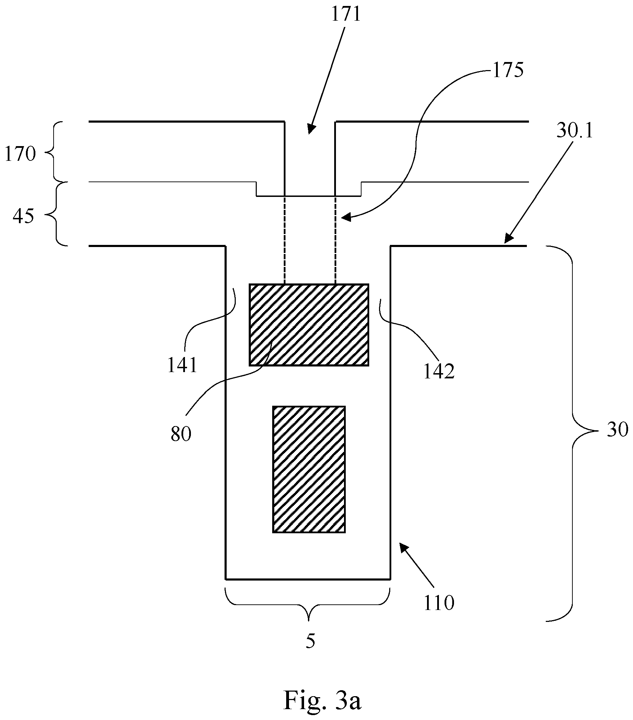

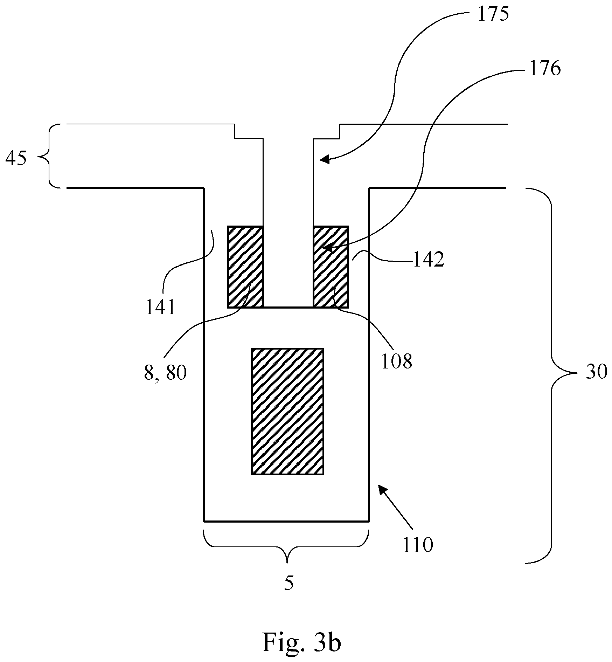

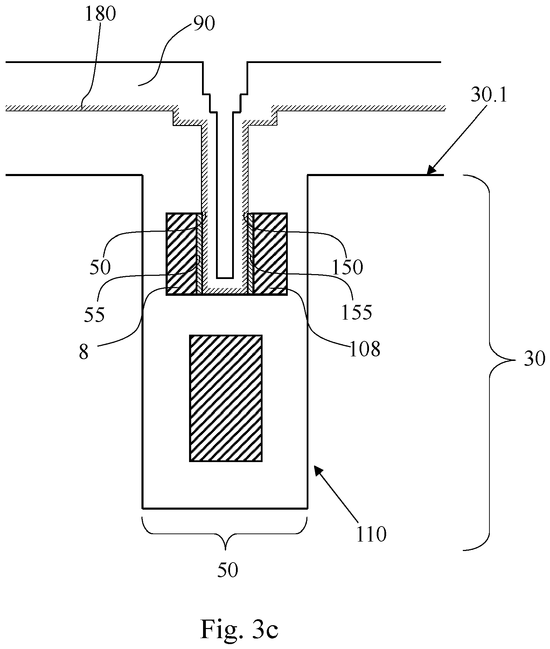

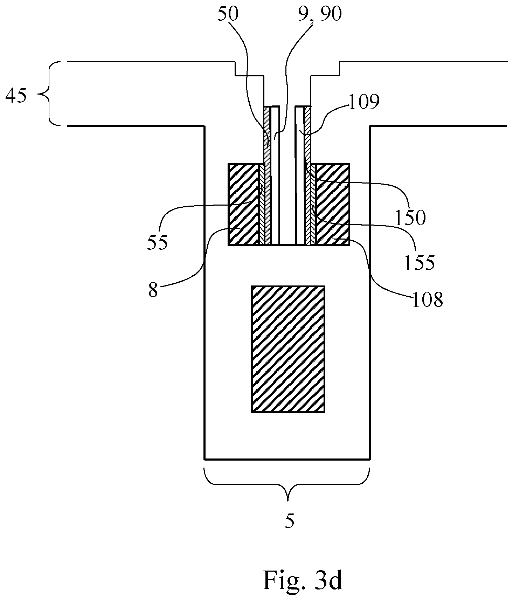

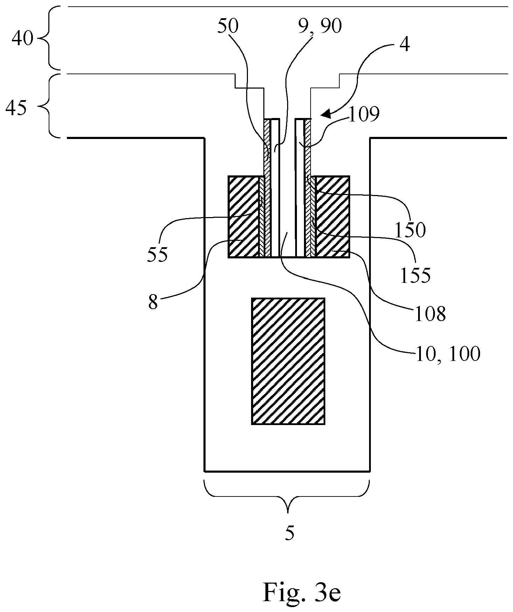

Figures 3 a illustrate some steps of manufacturing the gate electrode. In **figure 3a****,** the gate trench 5 has been etched and the field electrode region 110 has been formed already. In an upper portion of the gate trench 5, the outer gate material 80 has been deposited and the first and second gate dielectric 141, 142 have been formed. So far, this is a standard gate process for manufacturing a polysilicon gate in a trench. The outer gate material 80 is covered by the additional insulating layer 45 that has been deposited onto the first side 30.1 of the semiconductor body. On the additional insulating layer 45, a mask layer 170, which is a photoresist in the example shown, has been deposited and structured to provide an opening 171 centrally above the gate trench 5.

The opening 171 exposes the additional insulating layer 45 in a subsequent isotropic etch step. In a first step, a trench or groove 175 is etched into the additional insulating layer 45. In a second step, the additional insulating layer 45 with the groove 175 is used as a hard mask to etch a groove 176 into the outer gate material 80. Thus, the outer gate region 8 and additional outer gate region 108 are formed, see **figure 3b** where the mask layer has already been removed.

In **figure 3c****,** the silicide layers 55, 155 have been formed by depositing a thin titanium layer (for instance 2-5 nm) as a silicide formation layer and annealing this silicide formation layer, for instance at a temperature of around 650°C-750°C. Subsequently, to form the barrier layers 50, 150, a barrier layer material 180, for instance titanium nitride, has been deposited. The thickness may be around 5 nm-10 nm. Onto the barrier layer material 180, the metal material 90 has been deposited, for instance a tungsten layer with a thickness of around 100 nm.

**Figure 3d** illustrates a situation after an anisotropic etch step which leaves the barrier layers 50, 150 and the metal material 90 at the inner sidewalls of the groove, namely leaves the metal inlay region 9 and the additional metal inlay region 109. They can for instance have a respective thickness of around 50 nm. **Figure 3e** shows the gate electrode 4 after the spacer region 10 has been formed by a deposition of the spacer material 100. In the same process step, the insulating layer 40 has been formed, it is made of the same continuous spacer material 100, namely doped silicon oxide in this example. Via a thermal step, for instance in the range of 850°C-1000°C, the insulating layer 40 has been planarized.

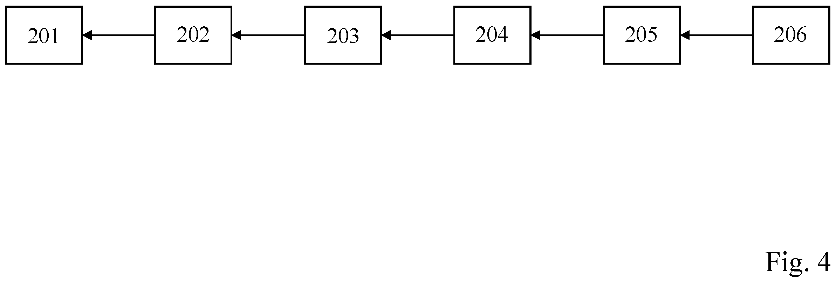

The flow diagram of figure 4 summarizes some manufacturing steps. After etching 201 the vertical gate trench, the outer gate material is deposited 202 into the gate trench. Then, the outer gate material is etched 203 to form the outer gate region prior to depositing 204 the metal material for metal inlay region. After etching back 205 the metal material, the spacer region is formed 206.

## Claims

1. A semiconductor device (1) having:
a gate electrode (4) in a vertical gate trench (5);
a channel region (6) laterally aside the gate trench (5);
wherein the gate electrode (4) comprises:
an outer gate region (8) made of an outer gate material (80);
a metal inlay region (9) made of a metal material (90);
a spacer region (10);
wherein the outer gate material (80) and the spacer region (10) are each different from the metal material (90),
and wherein the spacer region (10), the metal inlay region (9) and the outer gate region (8) are, at least in a vertical section (4.1) of the gate electrode (4), consecutively arranged from a center position (20) within the gate electrode (4) laterally outwardly towards the channel region (6).

2. The semiconductor device (1) of claim 1, wherein the spacer region (10) is made of a spacer material (100) which is different from the metal material (90).

3. The semiconductor device (1) of claim 2, wherein the spacer material (100) is a silicon material, in particular an electrically insulating silicon material.

4. The semiconductor device (1) of any one of the preceding claims, wherein the outer gate material (80) is an electrically conductive silicon material.

5. The semiconductor device (1) of any one of the preceding claims, wherein the metal inlay region (9) has a lateral thickness of 200 nm at maximum.

6. The semiconductor device (1) of any one of the preceding claims, wherein the metal inlay region (9) extends further upwards than the outer gate region (8).

7. The semiconductor device (1) of any one of the preceding claims, the vertical gate trench (5) extending from a first side (30.1) of a semiconductor body (30) into the semiconductor body (30), an insulating layer (40) arranged at the first side (30.1) of the semiconductor body (30), wherein the insulating layer (40) is made of the same continuous spacer material (100) like the spacer region (10).

8. The semiconductor device (1) of claim 7, wherein an additional insulating layer (45) is arranged at the first side (30.1) of the semiconductor body (30), vertically between the insulating layer (40) and the semiconductor body (30).

9. The semiconductor device (1) of any one of the preceding claims, wherein a barrier layer (50) and/or a silicide layer (55) is arranged laterally between the outer gate region (8) and the metal inlay region (9).

10. The semiconductor device (1) of any one of the preceding claims, wherein the gate electrode (4) is formed without the spacer region (10) in a lateral portion where the gate electrode (10) is contacted by a vertical gate contact, in particular is formed without the metal inlay region (9).

11. The semiconductor device (1) of any one of the preceding claims, wherein the gate electrode (4) has a symmetrical design when viewed in a vertical cross-section, an additional channel region (106) arranged at a laterally opposite side of the gate trench (5).

12. A method of manufacturing a semiconductor device (1), in particular the semiconductor device (1) of any one of the preceding claims, comprising the steps:
i.) etching (201) a vertical gate trench (5);
ii.) depositing (202) an outer gate material (80) into the vertical gate trench (5);
iii.) etching (203) into the outer gate material (80) in the vertical gate trench (5) to form an outer gate region (8);
iv.) depositing (204) a metal material (90) into the vertical gate trench (5) to form a metal inlay region (9);
v.) forming (206) a spacer region (10), in particular by depositing spacer material (100) into the vertical gate trench (5).

13. The method of claim 12, comprising an etching step to etch back (205) the metal material (90) in the vertical gate trench (5) after step iv.) and prior to step v.).

14. The method of claim 12 or 13 for manufacturing a semiconductor device (1) with a gate electrode (4) comprising a silicide layer (55) laterally between the outer gate region (8) and the metal inlay region (9), the method comprising:
- depositing a silicide formation layer;
- annealing the silicide formation layer to form the silicide layer (55); wherein the annealing is performed prior to step iv.).

15. The method of any one of claims 12 to 14 for manufacturing a semiconductor device (1) with a gate electrode (4) comprising a silicide layer (55) and with a source contact plug (121) comprising a silicide layer (122), wherein the silicide layer (122) of the source contact plug (121) is formed after the silicide layer (55) of the gate electrode (4).
